Europäisches Patentamt

European Patent Office

Office européen des brevets

(11) Numéro de publication: **0 168 849**
**B1**

(12) # FASCICULE DE BREVET EUROPÉEN

(45) Date de publication du fascicule du brevet:
**12.10.88**

(21) Numéro de dépôt: **85200734.3**

(22) Date de dépôt: **10.05.85**

(51) Int. Cl.⁴: **H 01 B 3/08, H 01 B 3/12**

(54) **Mélange de départ pour une composition isolante, encre sérigraphiable comportant un tel mélange et utilisation de cette encre pour la réalisation de microcircuits hybrides sur substrat co-laminé.**

(30) Priorité: **18.05.84 FR 8407769**

(43) Date de publication de la demande:
**22.01.86 Bulletin 86/4**

(45) Mention de la délivrance du brevet:
**12.10.88 Bulletin 88/41**

(84) Etats contractants désignés:
**BE CH DE FR GB IT LI**

(56) Documents cité:
**EP-A-0 016 498**
**US-A-4 152 282**

(73) Titulaire: **Laboratoires d'Electronique et de Physique Appliquée L.E.P., 3, Avenue Descartes, F-94450 Limeil- Brévannes (FR)**
(84) Etats contractants désignés: **FR**

(73) Titulaire: **N.V. Philips' Gloeilampenfabrieken, Groenewoudseweg 1, NL- 5621 BA Eindhoven (NL)**
(84) Etats contractants désignés: **BE CH DE GB IT LI**

(72) Inventeur: **Baudry, Hugues, Société Civile S.P.I.D. 209 Rue de l'Université, F-75007 Paris (FR)**

(74) Mandataire: **Landousy, Christian, Société Civile S.P.I.D. 209, Rue de l'Université, F-75007 Paris (FR)**

**0 168 849**

## Description

L'invention concerne la formulation d'un mélange de départ pour une composition isolante, comprenant une phase vitreuse et plusieurs phases céramiques dans les proportions volumiques respectives pour la phase vitreuse entre 85 et 60 % et pour les phases céramiques entre 15 et 40 %, la phase vitreuse étant un silicate de zinc et d'alcalinoterreux.

L'invention concerne également une encre sérigraphiable solante comportant un tel mélange.

L'invention concerne enfin un procédé de réalisation d'un microcircuit en technologie hybride sur un substrat co-laminé.

L'invention trouve son application dans la réalisation de microcircuits de puissance ou de support de boîtier pour les composants de grande surface dans le domaine des circuits intégrés.

Il est en effet connu par l'article de J.P DELLA MUSSIA dans la revue "Electronique actualités" du 9 mars 1984, page 15, intitulé "Les télécommunications étrangères homologuent les co-laminés d'Imphy" de substituer au substrat céramique traditionnel qui constitue le support des boîtiers de circuits intégrés, un nouveau substrat conducteur, dit "co-laminé", recouvert d'une couche électriquement isolante.

Ce co-laminé est constitué d'une lame d'un alliage de type INVAR (alliage fer-nickel contenant 36 % de nickel) dont chacune des faces reçoit un placage de cuivre, formant ainsi la succession de trois couches cuivre, INVAR, cuivre. Le co-laminé présente un coefficient de dilatation ajustable lors de la fabrication du fait que ce coefficient dépend des épaisseurs relatives des trois couches.

Un co-laminé où le triplet Cu/INVAR/Cu présente les pourcentages d'épaisseur 16/68/16 possède de nombreux avantages dont:

- Un coefficient de dilatation parallèlement à la surface très proche de celui de l'alumine et des différents semiconducteurs, entre 0 et 300°C.

- Une conductibilité thermique, parallèlement à la surface environ sept fois plus importante que celle de l'alumine. (Alors que la conductibilité thermique perpendiculairement à la surface est du même ordre de grandeur que celle de l'alumine). La fonction essentielle du co-laminé est donc de servir de radiateur aux circuits qui y sont déposés. Quand on sait qu'un circuit qui présente une grande densité d'intégration, ou un circuit de puissance, atteint souvent des températures de l'ordre de 100°C en fonctionnement, et que, à partir de 70°C, la durée de vie des composants est grossièrement divisée par deux tous les 7°C, on voit toute l'importance de la fonction radiateur.

- La possibilité de constituer des substrats de grande dimension, ce qui n'est pas le cas de l'alumine.

- La possibilité de constituer des substrats aussi minces que les substrats en alumine. Toutes les épaisseurs sont possibles, la plus faible épaisseur proposée à ce jour étant 35 µm.

- La possibilité de réaliser le blindage des circuits qui y sont déposes.

- La possibilité de souder au dos une couche de cuivre supplémentaire afin d'améliorer les propriétés de radiateur.

- La résistance aux chocs.

- La possibilité de perçage, pliage, emboutissage, découpe mécanique ou chimique.

- La possibilité d'être utilisé comme plan de masse des circuits qui y sont déposés.

Un autre co-laminé, qui possède une structure réfrigérante grâce à une circulation interne, présente de ce fait un avantage supplémentaire, et peut servir de substrat à des circuits prévus par exemple pour applications militaires, devant répondre aux normes -55, +125 °C.

Les co-laminés présentent, d'un autre côté, des inconvénients dont:

- Le fait qu'ils ne sont pas électriquement isolants en surface.

- Le fait qu'ils s'oxydent en surface s'ils ne sont pas protégés.

De l'ensemble de ces avantages et inconvénients, il s'ensuit que les co-laminés ont été prévus à l'origine pour servir de support et de radiateur aux substrats en céramique dits "CHIP CARRIER" des circuits intégrés ou à des composants de puissance ou de grande dimension, du fait de la compatibilité des coefficients de dilatation du co-laminé et de ces éléments, moyennant la réalisation en surface du co-laminé d'une couche électriquement isolante sur laquelle est formé le circuit de sortie desdits éléments.

Il est actuellement connu, comme il est décrit dans le document cité, de réaliser la couche isolante et ce circuit de sortie à l'aide de matériaux organiques polymérisables.

Mais ce procédé présente de nombreux inconvénients dont:

- La mauvaise tenue en température de ces matériaux, la température de polymérisation étant de l'ordre de 250°C.

- Le peu de solidité mécanique des matériaux polymérisables, ce qui ne permet pas de tirer parti de la grande solidité du substrat

- La mauvaise conductivité électrique des couches conductrices qui, étant des polymères chargés à l'argent, montrent une résistivité de $30.10^{-6}\,\Omega.$ cm.

- Le fait que ces conducteurs ne sont pas soudables.

- Le manque de finesse des conducteurs réalisés, qui ne permet pas de concevoir des circuits à haute densité d'intégration.

Au contraire, une encre conductrice sérigraphiable, telle que celle qui est décrite dans le brevet français n° 75 09 288, déposé par la Demanderesse, offre de nombreux avantages dont:

- La possibilité de supporter des températures élevées.

- Une grande solidité mécanique.
- La finesse des conducteurs permettant d'obtenir des circuits à haute densité d'intégration.
- La très bonne conductivité électrique de cette couche dont la résistivité est: $2.10^{-6}$ $\Omega$, cm.

Mais une telle encre conductrice sérigraphiable ne peut être utilisée directement sur le substrat co-laminé. Il convient d'interposer entre ce dernier et la première couche conductrice, une couche isolante à la fois parfaitement adaptée au co-laminé et à cette encre conductrice.

Le problème technique pose est donc le suvant: pour pouvoir profiter des avantages présentés par le nouveau substrat co-laminé en réalisant sur ce dernier des circuits à l'aide d'une encre sérigraphiable conductrice performante telle que citée, il convient de mettre au point une encre sérigraphiable isolante ($\varepsilon$ aussi faible que possible):
- De température de cuisson élevée lui permettant de pouvoir supporter la recuisson de la ou des couches conductrices envisagées.
- De coefficient de dilatation proche de celui du co-laminé, non seulement dans la gamme de températures comprises entre 0 et 300°, mais encore pour les températures comprises entre 300° et la température de cuisson de l'encre.
- Présentant une bonne adhérence sur le co-laminé.
- Présentant enfin la possibilité d'être cuite sous atmosphère non oxydante de manière à éviter l'oxydation du co-laminé.

Un mélange de départ pour une composition isolante apte à former une encore sérigraphiable isolante haute température à cuisson sous azote, est connu de l'art antérieur par EP-A-0 016 498 déposé par la Demanderesse. Selon ce document, ce mélange comprend une phase vitreuse constituée par les proportions molaires des oxydes suivants: de 30 à 55 % de silice ($SiO_2$), de 20 à 40 % d'oxyde de zinc (ZnO), de 0 à 20 % d'anhydride borique ($B_2O_3$), de 0 à 10 % d'alumine, de 5 à 40 % d'anhydride calcique (CaO), d'oxyde de strontium (SrO) et d'oxyde de baryum (BaO) ainsi que éventuellement de 0 à 10 % d'oxyde de cobalt (CoO), comme colorant. Ce mélange comprend en outre plusieurs phases céramiques telles que l'oxyde de zinc l'oxyde de cobalt, et des oxydes oxydants choisis parmi $Pr_6O_{11}$, $PrO_2$, $CrO_2$ et $CeO_2$.

Selon le document cité, un tel mélange dans les proportions volumiques comprises entre 85 et 60 % pour la phase vitreuse et entre 15 et 40 % pour les phases céramiques dispersé dans un véhicule organique, permet d'obtenir une encre sérigraphiable isolante, haute température, cuite sous azote et compatible avec l'encre conductrice citée précédemment. Mais cette encre est strictement appropriée à la réalisation de microcircuits hybrides sur substrats céramiques et conduit toujours, lorsqu'elle est utilisée sur co-laminé, à une déformation du substrat.

En effet, dans le but d'adapter cette encre au substrat co-laminé, tous les essais possibles de variation des proportions des constituants de l'encre proposée par le document cité ont été faits. L'adaptation n'a pas été obtenue.

Car de toutes les difficultés soulevées par la mise en oeuvre d'une telle encre, la plus compliquée à résoudre est l'adaptation du coefficient de température de l'encre avec celui du co-laminé. En tout état de cause, la solution du problème technique posé précédemment ne se trouve pas dans l'utilisation d'une encre réalisée selon le document cité.

C'est pourquoi la présente invention vise à fournir un nouveau mélange de départ pour une composition isolante tel que défini dans le préambule remarquable en ce que les phases céramiques incluent l'oxyde de zinc (ZnO), l'oxyde de cobalt ($Co_3O_4$) et le dioxyde de plomb ($PbO_2$).

Dans ces conditions, l'encre réalisée en dispersant une telle composition dans un véhicule organique, permet de résoudre le problème technologique posé et, particulièrement, présente un coefficient de dilatation bien adapté au substrat co-laminé choisi.

Selon une réalisation de l'invention, le mélange de départ est remarquable en ce que la phase vitreuse est constituée des proportions molaires des oxydes suivants 30 à 55 % de silice ($SiO_2$), 15 à 30 % d'oxyde de zinc (ZnO), 0 à 20 % d'anhydride borique ($B_2O_3$), 0 à 10 % d'alumine ($Al_2O_3$), 15 à 40 % d'oxyde de baryum (BaO) et en ce que dans les phases céramiques les proportions volumiques des oxydes sont comprises entre: 0 et 10 % pour l'oxyde de cobalt ($Co_3O_4$) zero étant exclu, 5 et 20 % pour l'oxyde de zinc (ZnO) et 10 et 25 % pour le dioxyde de plomb ($PbO_2$).

Selon une réalisation préférentielle, le mélange de départ est remarquable en ce que les proportions molaires de la phase vitreuse sont choisies égales à 45 % de silice ($SiO_2$), 20 % d'oxyde de zinc (ZnO), 5 % d'anhydride borique ($B_2O_3$), 5 % d'alumine ($Al_2O_3$), 25 % d'oxyde de baryum (BaO).

Selon cette réalisation préférentielle, le mélange de départ est remarquable en ce qu'il comporte en proportions volumiques 68 % de composé formant la phase vitreuse, associé à une phase céramique d'oxyde de zinc (ZnO) dans les proportions volumiques de 11 %, une phase céramique d'oxyde de cobalt ($Co_3O_4$) en proportion volumique de 2 % et une phase céramique de dioxyde de plomb ($PbO_2$) dans les proportions volumiques de 19 %.

L'encre sérigraphiable obtenue à partir de cette composition présente une température de ramollissement élevée qui permet le dépôt ultérieur des encres conductrices haute température envisagées. Le coefficient de dilatation de cette encre sérigraphiable isolante est extrêmement proche du coefficient de dilatation du co-laminé 16/68/16 cité, même jusqu'à des températures voisines de la température de solidification de l'encre. D'autre part cette encre admet une cuisson sous azote, ce qui permet d'éviter l'oxydation du co-laminé. Enfin les couches réalisées à l'aide de cette encre présentent une cohérence parfaite avec la surface du co-laminé, une grande planéité et une grande finesse permettant le dépôt ultérieur de couches conductrices haute définition.

La description qui va suivre, en regard des figures annexées, données à titre d'exemple de réalisation fera mieux comprendre comment l'invention est réalisée.

La figure 1 représente la courbe des allongements relatifs en fonction de la température du co-laminé (1), de l'alumine (2), du silicium (3), de l'arséniure de gallium (4), de l'isolant (5).

La figure 2 représente le montage d'un boîtier de type "CHIP CARRIER" sur un substrat co-laminé.

La figure 3 représente le montage d'un circuit réalisé sur semiconducteur ou semi-isolant sur un substrat co-laminé.

La figure 4 représente le montage d'éléments discrets sur un substrat co-laminé.

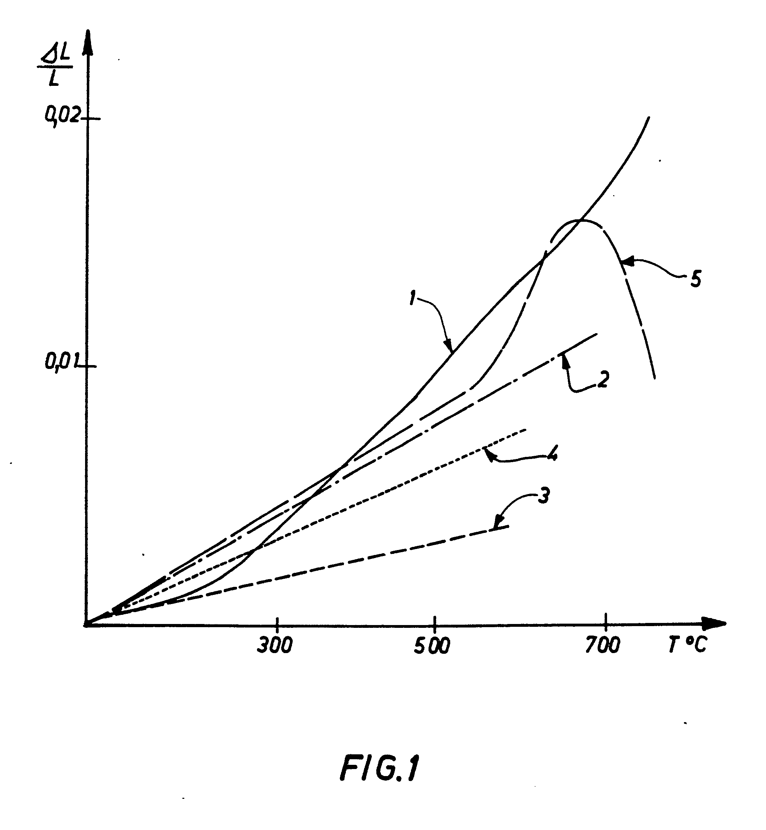

Tel que représenté sur la figure 1, l'allongement relatif de l'alumine (courbe 2) est très voisin de l'allongement relatif du colaminé de type 16/68/16 entre 0 et 300° (courbe 1). Au-delà de cette température, l'allongement relatif du co-laminé, dans les directions parallèles à sa surface, augmente très rapidement. Donc une encre sérigraphiable isolante, telle que l'encre décrite dans EP-A-0 016 498 cité précédemment, dont l'allongement relatif suit celui de l'alumine, opérerait sur la face de dépôt du co-laminé, lors du refroidissement après cuisson, un retrait, qui provoquerait l'apparition d'une surface arrière bombée. Au contraire l'encre sérigraphiable réalisée selon l'invention présente un allongement relatif moyen proche de celui du co-laminé jusqu'à la température de cuisson à environ 530°C (courbe 5 de la figure 1). Il ne se produit donc, lors du refroidissement après cuisson aucune déformation du substrat co-laminé.

L'originalité de la présente invention réside donc dans le fait d'utiliser à titre de phase céramique un mélange d'oxyde de zinc, d'oxyde de cobalt et d'oxyde de plomb, la composition de la phase vitreuse étant alors quelque peu différente des phases vitreuses connues de l'art antérieur.

Les compositions de verre utilisées sont précisées dans les tableaux suivants, les compositions A et B correspondant à deux exemples de réalisation (Tableau I), et le tableau II donnant des fourchettes de compositions possibles.

Tableau I

Phase vitreuse: composition molaire en %

|         | Exemple A | Exemple B (préféré) |
|---------|-----------|---------------------|
| ZnO     | 20        | 20                  |
| $SiO_2$ | 35        | 45                  |
| $B_2O_3$| 20        | 5                   |
| $Al_1O_3$| 10       | 5                   |
| BaO     | 15        | 25                  |

Mélange de départ: composition en volume

| Phase vitreuse ci-dessus |          | 68 % |
|--------------------------|----------|------|
|                          | ZnO      | 11 % |
| Phase céramiques         | $Co_3O_4$| 2 %  |
|                          | $PbO_2$  | 19 % |

|              | Exemple A | Exemple B |
|--------------|-----------|-----------|
| $10^7 \alpha$| 73        | 80        |
| $\rho$ (kg.m$^{-3}$) | 3394 | 3187   |
| P R S (°C)   | 615       | 550       |
| P R D (°C)   | 650       | 580       |

Tableau II

Phase vitreuse: composition molaire en %

| | |
|---|---|
| ZnO | 15 à 30 % |
| $SiO_2$ | 30 à 55 % |
| $B_2O_3$ | 0 à 20 % |
| $Al_2O_3$ | 0 à 10 % |
| BaO | 15 à 40 % |

Mélange de départ: composition en volume

| | | |
|---|---|---|
| Phase vitreuse ci-dessus | | 85 à 60 % |
| | ZnO | 5 à 20 % |
| Phases céramiques | $Co_3O_4$ | jusqu'à 10 %, zero étant exclu |
| | $PBO_2$ | 10 à 25 % |

Il est indiqué également dans le tableau I, outre la composition pour deux exemples étudiés, la masse volumique $\rho$ en kg par mètre-cube, le coefficient de dilatation $\alpha x 10^7$ par degré centigrade entre 20 et 320 degrés centigrades, le point de recuit supérieur en degrés centigrades (PRS), et le point de ramollissement dilatométrique (PRD) en degrés centigrades.

Pour mener à bien la réalisation d'une encre sérigraphiable selon la présente invention, on forme tout d'abord un verre dans les proportions molaires correspondant aux fourchettes indiquées dans le tableau II, ou mieux dans les proportions données comme préférentielles (exemple B, tableau I).

Le verre ainsi obtenu est broyé. Pendant cette opération sont incorporées les poudres d'oxyde de zinc (ZnO), de cobalt ($Co_3O_4$) et de plomb ($PbO_2$) afin d'obtenir un mélange homogène dans les proportons volumiques préférentielles de 68 % de verre, 11 % d'oxyde de zinc (ZnO), 2 % d'oxyde de cobalt ($Co_3O_4$) et 19 % de dioxyde de plomb ($PbO_2$).

Ce broyage peut être effectué dans un milieu liquide tel que l'eau. Le résultat du broyage est ensuite séché puis dispersé dans un véhicule organique.

En tant que véhicule organique propre à rendre ce mélange de départ sérigraphiable, on peut utiliser une solution contenant un polymère par exemple une solution d'éthyl cellulose dans un terpinéol, ou un mélange à base de terpinéol. Ce véhicule organique peut représenter avant cuisson 10 à 40 % en poids de l'encre sérigraphiable. Les proportions du véhicule organique par rapport à l'encre sont choisies en fonction du comportement rhéologique voulu.

Le véhicule organique doit être éliminé lors de la cuisson. Or, dans le but d'éviter l'oxydation des surfaces de cuivre du co-laminé, l'encre préparée et déposée sur ce substrat est soumise à une cuisson sous azote. Le véhicule organique ne peut être consumé lors d'une telle cuisson que grâce à l'oxygène fourni par les oxydes des phases céramiques et en particulier $Co_3O_4$.

C'est donc dans le but de fournir l'oxygène indispensable à l'alimentation du véhicule organique, que le plomb a été introduit sous forme de dioxyde ($PbO_2$) dans les phases céramiques.

Le rôle de l'oxyde de plomb est bien en premier lieu de permettre l'ajustement du coefficient de dilatation de l'encre selon des valeurs choisies.

Mais cet oxyde de plomb ne pourrait être introduit directement dans la phase vitreuse, car dans ce cas la quantité d'oxygène fournie par la phase céramique $Co_3O_4$ serait insuffisante. Il faudrait alors augmenter les proportions des phases céramiques, et l'ajustement du coefficient de dilatation aux valeurs voulues ne serait plus obtenu.

Au contraire en introduisant le plomb sous forme de dioxyde ($PbO_2$) dans les phases céramiques, les quantités d'oxygène en jeu sont suffisantes pour consumer le véhicule organique lors de la cuisson, et l'oxyde de plomb (PbO) qui en résulte entre à ce moment-là dans la phase vitreuse permettant l'ajustement du coefficient de dilatation souhaité.

Enfin la composition selon l'invention présente un avantage supplémentaire. La phase vitreuse est spontanément dévitrifiable grâce à sa teneur en oxyde de zinc. Cette dévitrification augmente le point de fusion de la couche par formation d'une phase cristalline dispersée moins fusible. Cette propriété évite un étalement de la couche isolante lors de la cuisson de la couche conductrice déposée ultérieurement à sa surface. D'autre part l'oxyde de zinc constituant une des phases céramiques vient renforcer cet effet, car il devient un agent dévitrifiant après dissolution dans la phase vitreuse.

Plusieurs types d'utilisation de l'encre réalisée selon l'invention sont possibles.

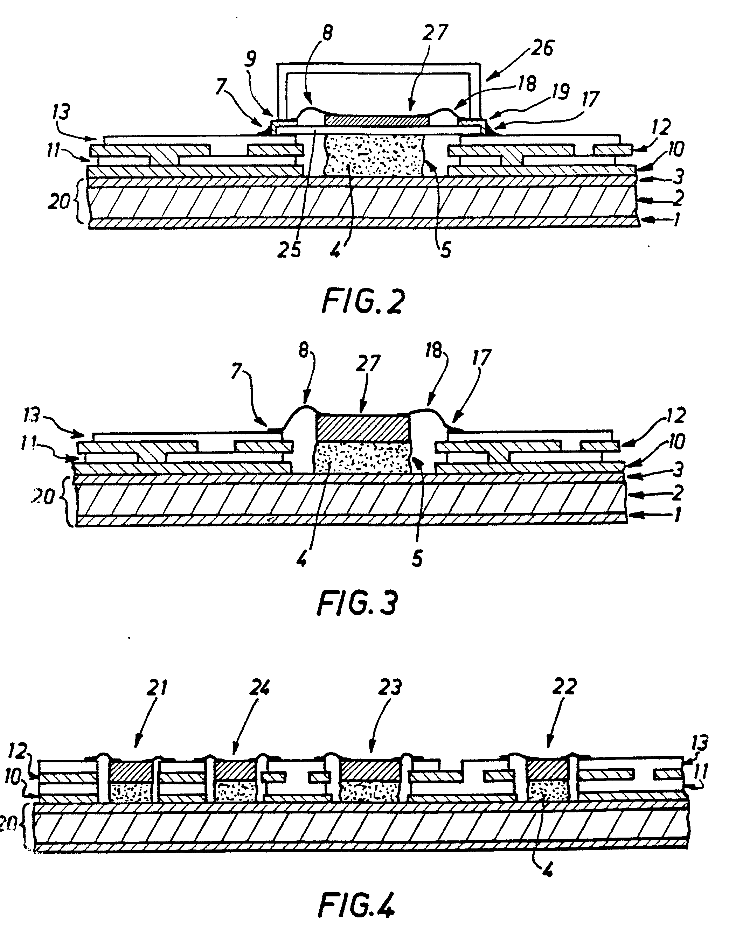

Un premier exemple d'utilisation est illustré par la figure 2. Tel que représenté sur cette figure, le dispositif réalisé comprend d'abord le substrat co-laminé 20 composé de deux couches de cuivre 1 et 3 plaquées respectivement sur chaque face d'une lame d'INVAR 2. Sur la couche supérieure 3, est déposée la couche sérigraphiée isolante 10 conformément à l'invention selon un motif qui ménage des ouvertures pour permettre de raccorder le dos 25 du boîtier 25, 26 sur le substrat. Ce peut être, par exemple, une ouverture 5 de surface légèrement inférieure à la surface d'un boîtier ou "CHIP CARRIER" 25, 26 destiné à être fixé ultérieurement sur ce substrat. Sur la couche isolante 10 est ensuite déposée une série de couches alternativement conductrices et isolantes réalisées à l'aide d'encres sérigraphiables haute température, en respectant un motif prévu pour constituer le circuit de connexion du CHIP CARRIER avec les plots de sortie du dispositif qui sont implantés sur la couche isolante 10 à la périphérie du substrat co-laminé 20. La première couche réalisée sur la couche isolante 10 peut être une couche conductrice 11 du type décrit dans FR-A-7 509 288. La couche suivante peut être une couche isolante 12 qui sera alors impérativement du type décrit dans la présente invention pour les raisons d'adaptation à la couche conductrice d'une part et au coefficient de dilatation du substrat d'autre part, raisons qui ont été exposées précédemment. On peut réaliser de cette façon jusqu'à cinq couches conductrices de type 11, séparées par des couches isolantes selon l'invention. Ainsi, la figure 2 montre les couches isolantes 10, 12, séparant les couches conductrices 11, 13. Il peut ensuite être déposé dans l'ouverture ménagée 5 pour recevoir le CHIP CARRIER 25, 26 une pâte à souder 4 sérigraphiable à l'étain-plomb (Sn-Pb, 60-40). Le CHIP CARRIER 25, 26 sera fixé ensuite à l'emplacement prévu par refusion de cette couche. Le CHIP CARRIER lui-même contient un microcircuit 27 réalisé sur silicium ou arséniure de gallium dont les sorties sont faites par des fils 8 et 18 raccordés aux plots de sortie 9 et 19 du CHIP CARRIER. Ces plots sont eux-mêmes raccordés aux couches conductrices du type de la couche 11 ou 13 par les points soudés 7 et 17. Le CHIP CARRIER est toujours posé sur une couche conductrice.

Un second exemple d'utilisation est illustré par la figure 3. Dans cet exemple le microcircuit 27 est fixé directement sur le substrat co-laminé 20, soit à l'aide d'un verre fusible sérigraphié, soit par collage soit à l'aide d'un alliage or-silicium (Au-Si) 4, après la réalisation sur le co-laminé d'un circuit hybride de connexions périphériques constitué d'une série de couches alternativement isolantes et conductrices du type des couches 10 et 11 décrites précédemment.

Un troisième exemple d'utilisation est illustré par la figure 4. Dans cet exemple, le co-laminé 20 protégé par la couche isolante 10 selon l'invention reçoit des éléments actifs tels que diodes 21 et transistors 22, et passifs tels que résistances 23, capacités 24 et inductances, dont toutes les interconnexions sont réalisées à l'aide d'encres sérigraphiables du type des couches 10 et 11 décrites précédemment. La fixation des éléments discrets peut être faite à l'aide de couches 4 de verre fusible sérigraphié ou d'alliage or-silicium (Au-Si) comme il a été vu plus haut. Les éléments actifs peuvent être réalisés sur des substrats semiconducteurs, silicium (Si) par exemple ou semi-isolant arséniure de gallium (GaAs) par exemple. Les éléments passifs peuvent être réalisés sur alumine.

Comme le montre la figure 1, les courbes d'allongement relatif du silicium (courbe 3) de l'alumine (courbe 2) de l'arséniure de gallium (courbe 4) enseignent que la fixation de ces matériaux est parfaitement compatible avec le substrat co-laminé dont l'allongement relatif est représenté courbe 1, ceci jusqu'à 200° environ pour le silicium et 300° environ pour l'arséniure de gallium et l'alumine.

En fixant directement les composants, microcircuits ou éléments discrets sur le co-laminé comme il est montré dans le second et le troisième exemple de réalisation, on profite de conditions améliorées pour le refroidissement de ces composants.

Dans chacun des trois exemples cités, le procédé de réalisation comprend les étapes de:

1. Dépôt de la couche isolante selon l'invention par sérigraphie à travers un écran selon un motif choisi et cuisson de cette couche.

2. Dépôt d'une couche conductrice par exemple telle que décrite dans le brevet n° 75 09 288, à travers un écran de sérigraphie selon un motif choisi et cuisson de cette couche.

3. Répétition des opérations 1 et 2 jusqu'à l'obtention du circuit prevu.

4. Fixation des éléments CHIP CARRIER, microcircuits ou éléments discrets à l'aide de pâtes à souder sérigraphiables appropriées.

5. Eventuellement protection locale des éléments isolés, autres que le CHIP CARRIER, par une encapsulation. A ce niveau, une telle encapsulation peut être faite sans problème par une goutte polymère 3, puisqu'il s'agit d'une simple protection et non d'une partie du circuit qui doit présenter une certaine solidité.

A titre d'indication on notera que des circuits ainsi réalisés ont présenté pour la couche isolante selon l'invention une constante diélectrique $\varepsilon_r = 12$ mesurée à 1 MHz, des pertes diélectriques inférieures à $3.10^{-2}$, et une résistance à l'isolement supérieure à $10^{11}\ \Omega$ pour un condensateur de 5 x 5 mm$^2$.

## Revendications

1. Mélange de départ pour une composition isolante comprenant une phase vitreuse et plusieurs phases céramiques, dans les proportions volumiques respectves pour la phase vitreuse entre 85 et 60 % et pour les phases céramiques entre 15 et 40 %, la phase vitreuse étant un silicate de zinc et d'alcalino-terreux, caractérisé en ce que les phases céramiques incluent l'oxyde de zinc (ZnO), l'oxyde de cobalt (Co$_3$O$_4$) et le dioxyde de plomb (PbO$_2$).

2. Mélange de départ selon la revendication 1, caractérisé en ce que la phase vitreuse est constituée des proportions molaires des oxydes suivants: 30 à 55 % de silice (SiO$_2$), 15 à 30 % d'oxyde de zinc (ZnO), 0 à 20 % d'anhydride borique (B$_2$O$_3$), 0 à 10 % d'alumine (Al$_2$O$_3$), 15 à 40 % d'oxyde de baryum (BaO).

3. Mélange de départ selon l'une des revendications 1 ou 2, caractérisé en ce que dans les phases céramiques les proportions en volume des oxydes sont comprises entre: 0 à 10 % pour l'oxyde de cobalt (Co$_3$O$_4$), le zéro étant exclu, 5 et 20 % pour l'oxyde de zinc (ZnO) et 10 et 25 % pour le dioxyde de plomb

(PbO$_2$).

4. Mélange de départ selon l'une des revendications 1 à 3, caractérisé en ce que les proportions molaires de la phase vitreuse sont choisies égales à 45 % de silice (SiO$_2$), 20 % d'oxyde de zinc (ZnO), 5 % d'anhydride borique (B$_2$O$_3$), 5 % d'alumine (Al$_2$O$_3$) et 25 % d'oxyde de baryum (BaO).

5. Mélange de départ selon l'une des revendications 1 à 4, caractérisé en ce qu'il comporte en proportions volumiques 68 % du composé formant la phase vitreuse, associé à une phase céramique d'oxyde de zinc (ZnO) dans les proportions volumiques de 11 %, une phase céramique d'oxyde de cobalt (Co$_3$O$_4$) dans les proportions volumiques de 2 % et une phase céramique de dioxyde de plomb (PbO$_2$) dans les proportions volumiques de 19 %.

6. Encre sérigraphiable caractérisée en ce qu'elle est formée par la dispersion dans un véhicule organique tel qu'une solution d'éthyl cellulose dans du terpinéol, d'un mélange de départ selon l'une des revendications 1 à 5.

7. Dispositifs électriques caractérisés en ce qu'ils sont constitués d'au moins une couche, ou d'un empilement de couches incluant une encre sérigraphiable selon la revendication 6, déposées sur un substrat conducteur cuivre-INVAR-cuivre co-laminé, à travers un écran de sérigraphie et cuites sous atmosphère d'azote à une température de palier comprise entre 850°C et 950°C pendant au moins 5 minutes.

**Patentansprüche**

1. Ausgangsmischung für eine Isolierzusammensetzung mit einer Glasphase und mehreren Keramikphasen, wobei in den betreffenden Volumenverhältnissen für die Glasphase zwischen 85 und 60 % und für die Keramikphase zwischen 15 und 40 %, die Glasphase ein Zink- und Erdalkalisilikat ist, dadurch gekennzeichnet, dass die Keramikphasen Zinkoxid (ZnO), Kobaltoxid (Co$_3$O$_4$) und Bleidioxid (PbO$_2$) aufweisen.

2. Ausgangsmischung nach Anspruch 1, dadurch gekennzeichnet, dass die Glasphase aus Molverhältnissen der nachfolgenden Oxide besteht: 30 bis 55 % Siliziumoxid (SiO$_2$), 15 bis 30 % Zinkoxid (ZnO), 0 bis 20 % Boranhydrid (B$_2$O$_3$), 0 bis 10 % Aluminiumoxid (Al$_2$O$_3$), 15 bis 40 % Bariumoxid (BaO).

3. Ausgangsmischung nach einem der Ansprüche 1 oder 2, dadurch gekennzeichnet, dass in den Keramikphasen die Volumenverhältnisse der Oxide zwischen 0 und 10 % für das Kobaltoxid (CO$_3$O$_4$) liegen, wobei Null ausgeschlossen ist, zwischen 5 und 20 % für das Zinkoxid (ZnO) und zwischen 10 und 25 % für das Bleidioxid (PbO$_2$) liegen.

4. Ausgangsmischung nach einem der Ansprüche 1 bis 3, dadurch gekennzeichnet, dass die Molverhältnisse der Glasphase gleich 45 % Siliziumoxid (SiO$_2$), 20 % Zinkoxid (ZnO), 5 % Boranhydrid (B$_2$O$_3$), 5 % Aluminiumoxid (Al$_2$O$_3$) und 25 % Bariumoxid (BaO) gewählt werden.

5. Ausgangsmischung nach einem der Ansprüche 1 bis 4, dadurch gekennzeichnet, dass sie in Volumenverhältnissen 68 % der die Glasphase bildenden Zusammensetzung aufweist, und dabei eine Keramikphase von Zinkoxid (ZnO) in Volumenverhältnissen gleich 11 %, eine Keramikphase von Kobaltoxid (Co$_3$O$_4$) in Volumenverhältnissen gleich 2 % und eine Keramikphase von Bleidioxid (PbO$_2$) in Verhältnissen gleich 19 %.

6. Siebdrucktinte, dadurch gekennzeichnet, dass diese aus der Dispersion in einem organischen Träger, wie einer Äthylzelluloselösung in Terpineol, einer Ausgangslösung nach einem der Ansprüche 1 bis 5 besteht.

7. Elektrische Anordnungen, dadurch gekennzeichnet, dass diese aus mindestens einer Schicht oder aus einer Stapelung von Schichten besteht mit einer Siebdrucktinte nach Anspruch 6, wobei diese Schichten durch ein Siebdrucksieb auf einem leitenden aus Kupfer-INVAR-Kupfer bestehenden Kolaminat-Substrat angebracht und bei einer Spitzentemperatur zwischen 850°C und 950°C während mindestens 5 Minuten in einer Stickstoffatmosphäre gebrannt werden.

**Claims**

1. A starting mixture for an insulating composition comprising a vitreous phase and several ceramic phases in the respective ratios by volume for the vitreous phase between 85 and 60 % and for the ceramic phases between 15 and 40 %, the vitreous phase being a silicate of zinc and alkaline earth, characterized in that the ceramic phases include zinc oxide (ZnO), cobalt oxide (Co$_3$O$_4$) and lead dioxide (PbO$_2$).

2. A starting mixture as claimed in claim 1, characterized in that the vitreous phase is constituted by molar ratios of the following oxides: 30 to 55 % of silicon (SiO$_2$), 15 to 30 % of zinc oxide (ZnO), 0 to 20 % of boric anhydride (B$_2$O$_3$), 0 to 10 % of alumina (Al$_2$O$_3$), 15 to 40 % of barium oxide (BaO).

3. A starting mixture as claimed in any of the Claims 1 or 2, characterized in that in the ceramic phases the ratios by volume of the oxides are between 0 and 10 % for cobalt oxide (Co$_3$O$_4$) zero being excluded, 5 and 20 % for zinc oxide (ZnO) and 10 and 25 % for lead dioxide (PbO$_2$).

4. A starting mixture as claimed in any of the Claims 1 to 3, characterized in that the molar ratios of the vitreous phase are chosen to be equal to 45 % of silicon (SiO$_2$), 20 % of zinc oxide (ZnO), 5 % of boric anhydride (B$_2$O$_3$), 5 % of alumina (Al$_2$O$_3$) and 25 % of barium oxide (BaO).

5. A starting mixture as claimed in any of the Claims 1 to 4, characterized in that it comprises in ratios by volume 68 % of the compound forming the vitreous phase, associated with a ceramic phase of zinc oixde (ZnO) in the ratios by volume of 11 %, a ceramic phase of cobalt oxide ($Co_3O_4$) in the ratios by volume of 2 % and a ceramic phase of lead dioxide ($PbO_2$) in the ratios by volume of 19 %.

6. A silk-screening ink characterized in that it is formed by the dispersion of a starting mixture as claimed in any of the Claims 1 to 5 in an organic carrier such as a solution of ethyl-cellulose in a terpineol.

7. Electric devices, characterized in that they are constituted by at least one layer, or a pile of layers including a silk-screening ink as claimed in Claim 6, deposited on a colaminated conductive substrate of copper-invar-copper, through a silk-screening screen and fired under an atmosphere of nitrogen at a peak temperature between 850° C and 950° C for at least 5 minutes.

FIG.1

FIG.2

FIG.3

FIG.4